# EUROPEAN PATENT APPLICATION

(11) **EP 2 722 895 A1**
(43) Date of publication of application: **23.04.2014**
(21) Application number: 12797499.6
(22) Date of filing: 08.06.2012
(51) Int. Cl.: H01L 31/042

(54) **SOLAR CELL MODULE, METHOD FOR MANUFACTURING SOLAR CELL MODULE, METHOD FOR BONDING ADHESIVE FILM, AND METHOD FOR INSPECTING ADHESIVE FILM**

(30) Priority: 08.06.2011 JP 2011128507
(71) Applicant: Dexerials Corporation, Tokyo 141-0032 (JP)
(72) Inventor: FUJII, Takahiro, Tokyo 141-0032 (JP); SUGA, Yasuhiro, Tokyo 141-0032 (JP); OKUMIYA, Hideaki, Tokyo 141-0032 (JP); HIGUCHI, Akifumi, Tokyo 141-0032 (JP); SHIN, Yasumasa, Tokyo 141-0032 (JP)
(74) Representative: Müller - Hoffmann & Partner
(86) International application number: PCT/JP2012/064828
(87) International publication number: WO 2012/169626

(57) **Abstract**

To detect a positional shift of an adhesive film relative to the bonding position at which the adhesive film is bonded to an electrode of a solar cell. A plurality of solar cells (2) and tab wires (3), which are bonded to electrodes (11) and (13) respectively formed on a light-receiving surface of each solar cell and a back surface of an adjacent solar cell (2), with an adhesive film (17) interposed therebetween, so as to mutually bond the plural solar cells (2) to one another, are prepared, and the adhesive film (17) has a color that is recognized as a different color from the color of the bonding surface of the solar cell (2), when image-processed.

## Description

### Field of the Invention

This invention relates to a solar cell module in which a plurality of solar cells are connected with one another by tab wires, and in particular concerns a solar cell module in which an adhesive film for use in bonding the tab wires to the electrodes of the solar cells is bonded to the electrodes of the solar cell, a method for manufacturing such a solar cell module, a method for bonding the adhesive film and an inspection method for the adhesive film.

The present application asserts priority rights based on JP Patent Application 2011-128507 filed in Japan on June 8, 2011. The total contents of disclosure of the Patent Application of the senior filing date are to be incorporated by reference into the present Application.

### Background of the Invention

For example, in a crystal silicon-based solar cell module, a plurality of adjacent solar cells are connected by tab wires forming interconnectors. Each tab wire has its one end connected to surface electrodes of one solar cell and the other end connected to a back surface electrode of an adjacent solar cell so that the respective solar cells are connected in series with one after another. At this time, the tab wire has one surface of the one end bonded to the surface electrode of one solar cell, with the other surface of the other end being bonded to the back surface electrode of the adjacent solar cell.

More specifically, in the solar cell, busbar electrodes are formed on its light-receiving surface by screen-printing silver paste thereon, or the like, and an Ag electrode is formed on a back surface connection portion. Additionally, on regions other than the connection portion on the back surface of the solar cell, Al electrodes and Ag electrodes are formed.

Moreover, the tab wires are formed, for example, by placing solder coat layers on the two surfaces of a ribbon-shaped copper foil. More specifically, the tab wire is formed through processes in which a copper foil rolled into a thickness of about 0.05 to 0.2 mm is slit or a flat square copper wire having a width of 1 to 3 mm obtained by rolling a copper wire, or the like, into a flat-plate shape is subjected to a solder plating process or a dip soldering process.

The connection between the solar cell and the tab wires is carried out through processes in which the tab wires are disposed on the respective electrodes of the solar cells and by carrying out heating and pressing processes thereon by using a heating bonder, the solder formed on the surfaces of the tab wires is melted and then cooled (Patent Document 1).

However, in the soldering process, since a connection process is carried out at a high temperature of about 260 °C, connection reliability between the surface electrodes as well as the back surface electrodes and the tab wires of the solar cells might be lowered, due to warps and cracks in the solar cells, an inner stress caused in the connection portion between the tab wires and the surface electrodes as well as the back surface electrodes, and residues of fluxes or the like.

Therefore, conventionally, with respect to connection between the surface electrodes and back surface electrodes of a solar cell, a conductive adhesive film capable of being connected by a thermal press-bonding process at a comparatively low temperature has been used (Patent Document 2). As the conductive adhesive film of this type, a material, which is prepared by dispersing spherical or scale-shaped conductive particles having an average particle size in the order of several ums into a thermo-setting binder resin composition and formed into a film, has been used.

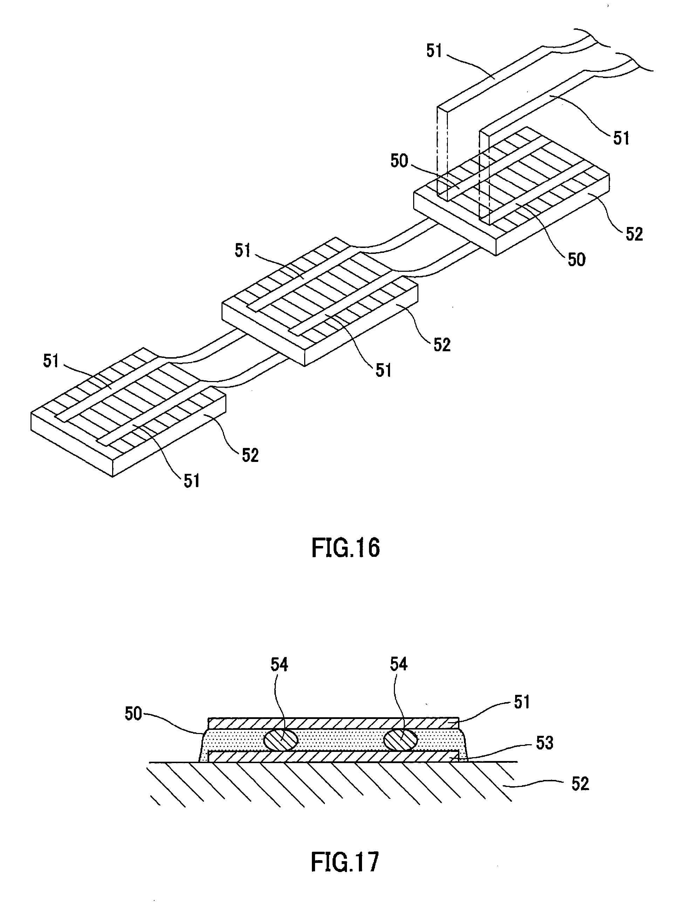

As shown in FIG. 16, on the conductive adhesive film 50 onto which the surface electrodes and the back surface electrode have been bonded, tab wires 51 are superposed, and heating and pressing processes are carried out on the tab wires 51 by a heating bonder. Thus, as shown in FIG. 17, in the conductive adhesive film 50, a binder resin is allowed to exert flowability to flow out between the tab wires 51, with conductive particles 54 being sandwiched between electrodes 53 and tab wires 51 to provide conduction therebetween, and the binder resin is thermally cured in this state. Thus, strings in which the plural solar cells 52 are series-connected with one another by the tab wires 51 are formed.

A plurality of solar cells 52 in which the tab wires 51, the surface electrodes and the back surface electrodes are connected to one another by using the conductive adhesive film 50 are sealed between a surface protective member having a translucent property, such as glass, a translucent plastic material or the like, and a back surface protective member made of a film such as PET (Poly Ethylene Terephthalate) or the like, by using a sealing material having a translucent property, such as an ethylene vinyl acetate (EVA) or the like.

### Prior-Art Documents

### Patent Document

PTL 1: Japanese Patent Application Laid-Open No. 2004-356349
PTL 2: Japanese Patent Application Laid-Open No. 2008-135654
PTL 3: Japanese Patent Application Laid-Open No. 2010-16245

### Summary of the Invention

However, in the case when a positional shift occurs in a bonding process of a conductive adhesive film 50 onto an electrode 53 of a solar cell, on a device side to which tab wires 51 are bonded, a bonding process of the tab wires 51 is carried out without recognizing this positional shift. Then, the tab wires 51 are subjected to heating and pressing processes without being completely superposed on the conductive adhesive film 50, with the positional shift occurring therein, and then subjected to a main press-bonding process.

Consequently, the bonding area between the tab wires 51 and the electrodes 53 in the solar cell module becomes smaller, causing degradation of mechanical connection strength and electrical connection reliability. In the case when the positional shift of the bonding position of the conductive adhesive film 50 is large, a connection failure between the solar cell and the tab wires 51 becomes large to such an extent that as not to be applied to practical use, resulting in degradation of the yield of strings themselves.

On the other hand, in the bonding process of the conductive adhesive film 50, when the positional shift of the bonding position can be recognized, the conductive adhesive film 50 can be again re-bonded (repaired), making it possible to prevent the connection failure between the solar cell and the tab wires 51 from occurring.

Therefore, the object of the present invention is to provide a solar cell module in which the positional shift in the bonding position of the adhesive film bonded to the electrodes of the solar cell can be detected, a method for manufacturing such a solar cell module, a method for bonding the adhesive film and an inspection method for the adhesive film.

In order to solve the above-mentioned problems, a solar cell module in accordance with the present invention is provided with: a plurality of solar cells;
a plurality of tab wires that are bonded onto electrodes formed on a light-receiving surface of each solar cell and a back surface of an adjacent solar cell with an adhesive film interposed therebetween so as to mutually connect the plural solar cells, and in this configuration the adhesive film has a color that is recognized as a different color from the color of the bonding surfaces of the solar cells when image-processed.

Moreover, a method for manufacturing a solar cell module in accordance with the present invention is provided with: the steps of: carrying out an adhesive film disposing process in which an adhesive film is temporarily bonded to a predetermined bonding position on a surface of each solar cell; capturing an image of the surface of the solar cells on which the adhesive film has been temporarily bonded; by image processing image data on the surface of the solar cell, detecting whether or not the adhesive film is temporarily bonded to the predetermined position; carrying out a tab wire disposing step in which tab wires are temporarily bonded onto the adhesive film at a predetermined bonding position on the surface of the solar cell; and applying heating and pressing processes onto the tab wires so that the tab wires are connected to the surface of the solar cell by the adhesive film, and by this method, the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.

Moreover, a method for bonding an adhesive film in accordance with the present invention is provided with the steps of: carrying out an adhesive film disposing process in which an adhesive film is temporarily bonded to a predetermined bonding position on a surface of each solar cell; capturing an image of the surface of the solar cells on which the adhesive film has been temporarily bonded; and by image processing image data on the surface of the solar cell, detecting whether or not the adhesive film is temporarily bonded to the predetermined position, and by this method, the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.

Furthermore, a method for inspecting an adhesive film in accordance with the present invention is provided with the steps of: carrying out an adhesive film disposing process in which an adhesive film is temporarily bonded to a predetermined bonding position on a surface of each solar cell; capturing an image of the surface of the solar cells on which the adhesive film has been temporarily bonded; and by image processing image data on the surface of the solar cell, detecting whether or not the adhesive film is temporarily bonded to the predetermined position, and by this method, the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.

### Effects of Invention

In accordance with the present invention, since prior to connections of tab wires, a presence or absence of any positional shift of a conductive adhesive film is detected, the tab wires can be connected with the conductive adhesive film in a manner so as to be completely superposed thereon. Thus, the present invention makes it possible to maintain mechanical connection strength and electrical connection reliability of the tab wires, and consequently to also improve the yield of strings.

### Brief Description of Drawings

Figure 1 is an exploded perspective view showing a solar cell module.
Figure 2 is a cross-sectional view showing a string of solar cells.
Figure 3 is a plan view showing a back surface electrode and a connection portion of the solar cell.
Figure 4 is a cross-sectional view showing a conductive adhesive film.
Figure 5 is a view showing the conductive adhesive film wound around into a reel state.
Figure 6 is a flow chart showing a manufacturing process of a solar cell module.
Figure 7 is a side view showing a temporarily bonding process of the conductive adhesive film.
Figure 8 is a block diagram showing a configuration of a bonding position inspection device.
Figures 9A and 9B are views that show binary images of the solar cell.
Figures 10A and 10B are views that show binary images of a solar cell relating to embodiments.
Figures 11A and 11B are views that show binary images of a busbar-less solar cell relating to embodiments.
Figures 12A and 12B are views that show binary images of a solar cell relating to a comparative example.
Figures 13A and 13B are views that show binary images of a solar cell relating to another comparative example.
Figures 14A and 14B are views that show binary images of a solar cell relating to the other comparative example.
Figure 15 is a flow chart showing another manufacturing process of a solar cell module.
Figure 16 is a perspective view showing a conventional solar cell module.
Figure 17 is a cross-sectional view showing a connecting process of tab wires in the conventional solar cell module.

### Detailed Description of the Invention

Referring to Figures, the following description will discuss a solar cell module to which the present invention is applied, a method for manufacturing the solar cell module, a method for bonding adhesive films, and an inspection method for the adhesive film in detail.

### [Solar Cell Module]

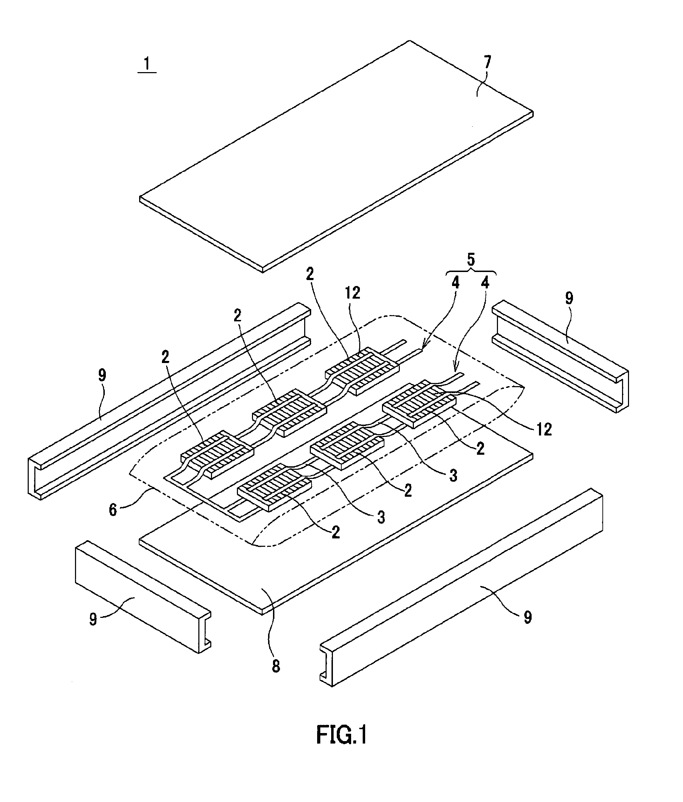

As shown in Figs. 1 to 3, a solar cell module 1 to which the present invention is applied is provided with strings 4 in which a plurality of solar cells 2 are connected to one after another by tab wires 3 forming interconnectors, and a matrix 5 in which a plurality of these strings 4 are arranged. Moreover, the solar cell module 1 is formed through processes in which this matrix 5 is sandwiched by sheets 6 made of a sealing adhesive, and laminated as one lot together with a surface cover 7 formed on a light-receiving surface side and a back sheet 8 formed on a back surface side, and lastly a metal frame 9 made of aluminum or the like is attached to the peripheral portion thereof.

As the sealing adhesive, for example, a translucent sealing material, such as an ethylene vinyl acetate resin (EVA) or the like, is used. As the surface cover 7, for example, a translucent material, such as glass or a translucent plastic material, is used. Moreover, as the back sheet 8, a laminate member or the like in which glass or an aluminum foil is sandwiched by resin films is used.

Each solar cell 2 of the solar cell module 1 is provided with a photoelectric conversion element 10. As the photoelectric conversion element 10, each of various types of photoelectric conversion elements 10, such as a crystal silicon-based solar cell using a single crystal-type silicon photoelectric conversion element and a multi-crystal-type silicon photoelectric conversion element, a thin-film silicon-based solar cell made of amorphous silicon, and a multi-joining type thin-film silicon-based solar cell in which a cell made of amorphous silicon and a cell made of microcrystal silicon or amorphous silicon germanium are stacked, that is, a so-called compound thin-film-based solar cell, an organic-based solar cell and a quantum-dot type solar cell, may be used.

Moreover, the photoelectric conversion element 10 is provided with finger electrodes 12 for use in collecting electricity generated inside thereof and a busbar electrode 11 for use in collecting the electricity of the finger electrodes 12, which are formed on a light-receiving surface side. The busbar electrode 11 and the finger electrodes 12 are formed through processes in which, after, for example, an Ag paste has been applied onto a surface forming the light-receiving surface of the solar cell 2 by a screen printing process or the like, the resulting solar cell 2 is baked. Moreover, the finger electrodes 12 are formed as a plurality of lines with a width of, for example, about 50 to 200µm, that are arranged virtually in parallel with one another with predetermined intervals, for example, every other 2 mm, over the entire surface of the light-receiving surface. The basbar electrode 11 is formed so as to be virtually orthogonal to the finger electrodes 12, and a plurality of them are formed in accordance with the area of the solar cell 2.

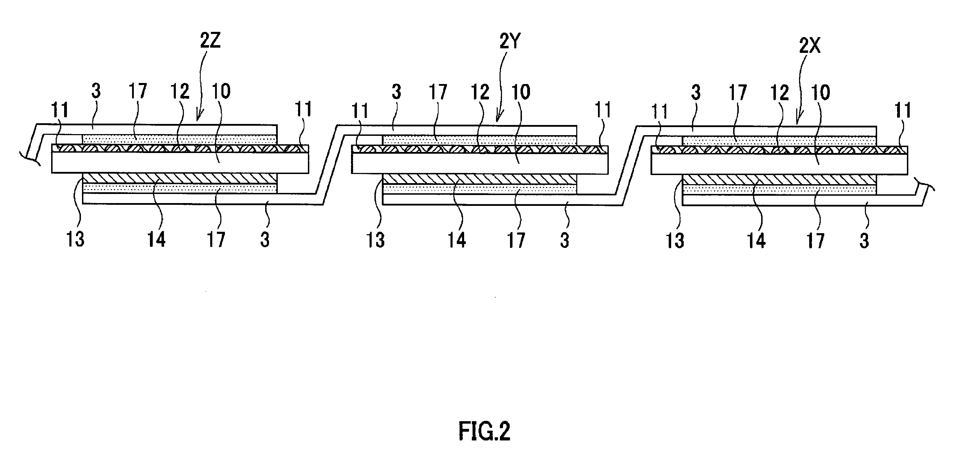

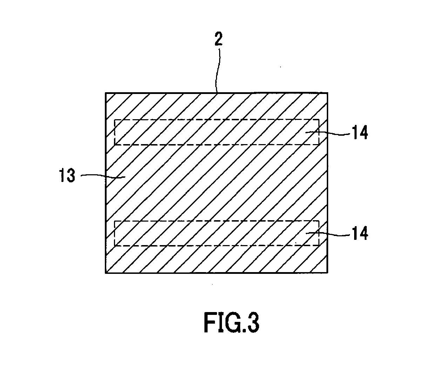

Furthermore, the photoelectric conversion element 10 is configured such that a back surface electrode 13 made of aluminum or silver is formed on a back surface side opposite to the light-receiving surface. As shown in Figs. 2 and 3, the back surface electrode 13 is formed as an electrode made of, for example, aluminum or silver, which is formed on the back surface of the solar cell 2 by using a screen printing process, a sputtering process, or the like. The back surface electrode 13 is provided with a conductive adhesive film 17 to be described later, bonded thereto, and has tab wire connection portions 14 to which tab wires 3 are connected with the conductive adhesive film 17 interposed therebetween.

Moreover, the solar cell 2 is configured such that each of the respective busbar electrodes 11 formed on the surface and a back surface electrode 13 of an adjacent solar cell 2 are electrically connected with each other so that strings 4, which are series-connected to each other, are formed. The tab wires 3, the busbar electrodes 11 and the back surface electrode 13 are connected to one another by a conductive adhesive film 17, which will be described later.

In general, the solar cell 2 has its light-receiving surface colored into dark blue, and a photographed image of the light-receiving surface is turned into black, for example, by an image processing by means of a binary process. Moreover, since the solar cell 2 has the back surface electrode 13, made of aluminum or silver, formed over the entire back surface, a photographed image of the back surface is converted into white, for example, by an image processing by means of a binary process.

### [Tab Wire]

As shown in FIG. 2, the tab wires 3 are elongated conductive base members that electrically connect adjacent solar cells 2X, 2Y and 2Z with one another. The tab wires 3 are prepared by slitting a copper foil or an aluminum foil rolled into, for example, a thickness of 50 to 300µm, or by rolling thin metal wires of copper, aluminum or the like into a flat plate shape, so as to obtain flat rectangular-shaped copper wires having a width of 1 to 3 mm, which is the same as that of the conductive adhesive film 17. Then, the tab wires 3 are formed by applying a gold plating, silver plating, tin plating, solder plating process or the like to the flat rectangular-shaped copper wires.

### [Conductive Adhesive Film]

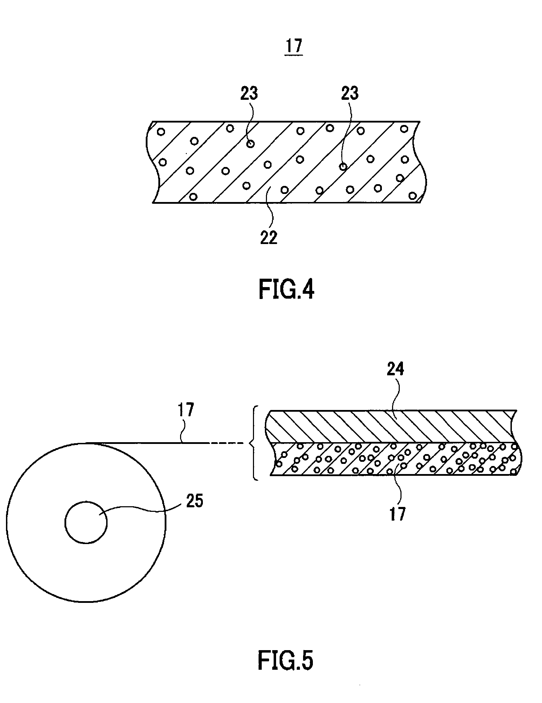

As shown in Fig. 4, the conductive adhesive film 17 is a thermo-setting binder resin layer in which spherical conductive particles 23 are contained in a binder resin 22 with a high concentration. The conductive adhesive film 17 to which the present invention is applied has a color that is recognized as a color different from the color of the adhesion surface of the solar cell 2 to which the conductive adhesive film 17 is bonded, when the photographed image is image processed. Thus, in the solar cell module 1, by carrying out an image processing based upon image data of the solar cell 2 to which the conductive adhesive film 17 is bonded, it is possible to detect a positional shift from the bonded position correctly. The detailed description thereof will be given later.

Moreover, from the viewpoint of indenting property, the conductive adhesive film 17 is preferably designed to have the lowest melt viscosity of the binder resin 22 in a range from 100 to 100000 Pa•s. When the lowest melt viscosity of the conductive adhesive film 17 is too low, the resin tends to flow from a low press-bonding process to a main curing process to easily cause any connection failure or any protrusion onto the cell light-receiving surface, resulting in a reduction in light receiving rate. Moreover, when the lowest melt viscosity is too high, a failure tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

### [Conductive Particles]

As the conductive particles 23 used for the conductive adhesive film 17, examples thereof include: metal particles such as nickel, gold, silver and copper, and resin particles serving as core members that are subj ected to gold plating or the like on the outermost layers thereof.

Moreover, the conductive adhesive film 17 preferably has a viscosity in a range from 10 to 10000 kPa•s, and more preferably, from 10 to 5000 kPa•s, at about normal temperature. By setting the viscosity of the conductive adhesive film 17 in the range from 10 to 10000 kPa•s, it becomes possible to prevent blocking due to so-called protrusion at the time when the conductive adhesive film 17 is wound into a reel state, and also to maintain a predetermined tacking strength.

### [Binder Resin]

Although not particularly limited, as long as the above-mentioned characteristics is not impaired, the composition of the binder resin 22 of the conductive adhesive film 17 preferably contains a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristics, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., the phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as a hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. Among these, in the present invention, the potential curing agent of a hot setting-type is preferably used, and the curing agent is subjected to a main curing process by being heated and pressed onto the busbar electrodes 11 and the back surface electrode 13. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, materials, such as silica, talc, titanium oxide, calcium carbonate, magnesium oxide or the like, may be used, and the kind of the inorganic filler is not particularly limited.

Fig. 5 is a schematic view that shows one example of a product mode of the conductive adhesive film 17. The conductive adhesive film 17 is provided with a peeling base member 24 with a binder resin 22 laminated thereon, and these are molded into a tape shape. This tape-shaped conductive adhesive film is wound around and stacked on a reel 25, with the peeling base member 24 being located on the peripheral side. As the peeling base member 24, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesive film 17 may have a structure in which a transparent cover film is formed on the binder resin 22.

### [Addition of Coloring Agent]

The color of the conductive adhesive film 17 is prepared as a color that is recognized as a different color from the color of the adhesion surface of the solar cell 2, when image-processed. For example, the color of the conductive adhesive film 17 to be bonded to the light-receiving surface side of the solar cell 2 is a color to be recognized as white by binary image processing. In the case of a crystal silicon-based solar cell 2, since the light-receiving surface has a dark blue color that is peculiar to silicon, this color is recognized as black by the binary image processing. Moreover, the color of the conductive adhesive film 17 to be bonded to the back surface of the solar cell 2 corresponds to a color that is recognized as black by the binary image processing. Since the back surface electrode made of Ag or Al is formed over the entire surface of the back surface of the crystal silicon-based solar cell 2 as described earlier, this color is recognized as white by the binary image processing.

In this case, the conductive adhesive film 17 to be bonded to the light-receiving surface side of the solar cell 2 is colored into a white-based color so as to be recognized as white by the binary image processing, by adding titanium oxide, zinc oxide or the like to the binder resin 22. Moreover, the conductive adhesive film 17 to be bonded to the back surface of the solar cell 2 is colored into a black-based color so as to be recognized as black by the binary image processing, by adding carbon black or the like to the binder resin 22.

Additionally, not limited to a reel shape, the conductive adhesive film 17 may have a stripe shape in accordance with the shape of the busbar electrodes 11 and the tab wire connection portion 14 of the back surface electrode 13.

In the case when, as shown in Fig. 5, the conductive adhesive film 17 is prepared as a reel product wound around the reel, by setting the viscosity of the conductive adhesive film 17 in a range from 10 to 10000 kPa•s, it becomes possible to prevent the conductive adhesive film 17 from being deformed, and consequently to maintain a predetermined dimension. In the case when two or more stripe-shaped conductive adhesive films 17 are stacked, it also becomes possible to prevent them from being deformed, and consequently to maintain a predetermined dimension.

### [Manufacturing Method-Detection Method]

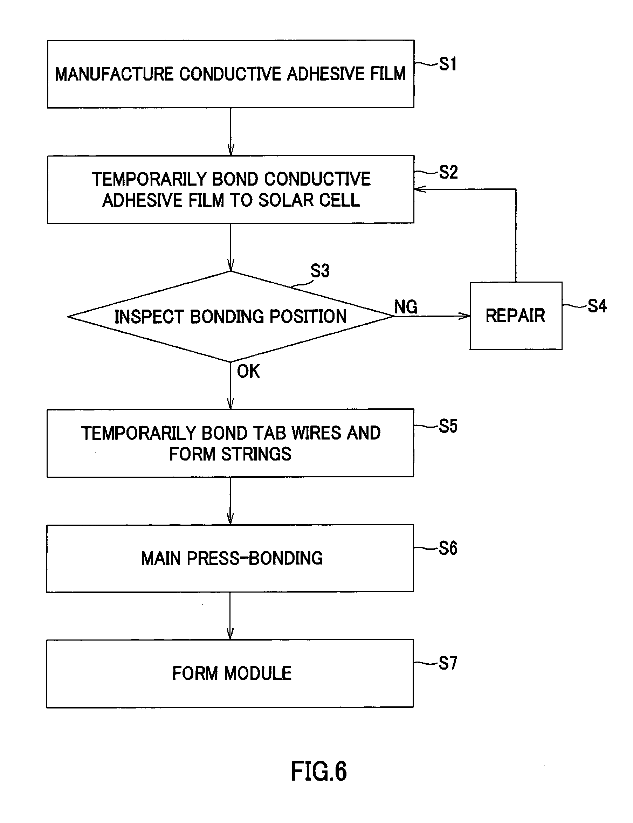

As shown in Fig. 6, the manufacturing process of the solar cell module 1 includes steps in which a conductive adhesive film 17 is produced (step S1), after the conductive adhesive film 17 has been temporarily bonded to the light-receiving surface and the back surface of the solar cell 2 (step S2), the resulting solar cell is subjected to a inspection process for a bonded position (step S3). In the case when any positional shift is detected by the inspection for a bonded position, the resulting solar cell is subjected to a repairing process (step S4) in which the conductive adhesive film 17 is again temporarily bonded thereto. In the case when no positional shift is detected, tab wires 3 are temporarily bonded among the plural solar cells 2 so that strings are formed (step S5). Thereafter, by carrying out heating and pressing processes onto the tab wires 3, the tab wires 3 and the respective electrodes of the solar cell 2 are mainly press-bonded with each other with the conductive adhesive film 17 being interposed therebetween (step S6), and by sealing the resulting cell between the surface cover and the back sheet by using a sealing sheet such as EVA or the like (step S7), a solar cell module 1 is manufactured. The following description will discuss the processes in detail.

The above-mentioned conductive adhesive film 17 is prepared by dissolving conductive particles 23, a film-forming resin, a liquid-state epoxy resin, a potential curing agent, a silane coupling agent, and a coloring agent, such as titanium oxide, zinc oxide, carbon black or the like, into a solvent. As the solvent, toluene, ethyl acetate or the like, or a mixed solvent of these, may be used. A resin-forming solution obtained by the dissolving process is applied onto a peeling sheet, and by evaporating the solvent, the conductive adhesive film 17 is obtained.

Moreover, the conductive adhesive film 17 is cut into predetermined lengths for use as two surface electrodes and two back surface electrodes, and these are temporarily bonded to predetermined positions on the surface and back surface of the solar cell 2. At this time, the conductive adhesive film 17 colored into a white-based color is temporarily bonded onto the respective busbar electrodes 11 the plural of which are formed on the surface of the solar cell 2 virtually in parallel with one another, while the conductive adhesive film 17 colored into a black-based color is temporarily bonded onto the connection portions 14 of the tab wires of the back surface electrode 13.

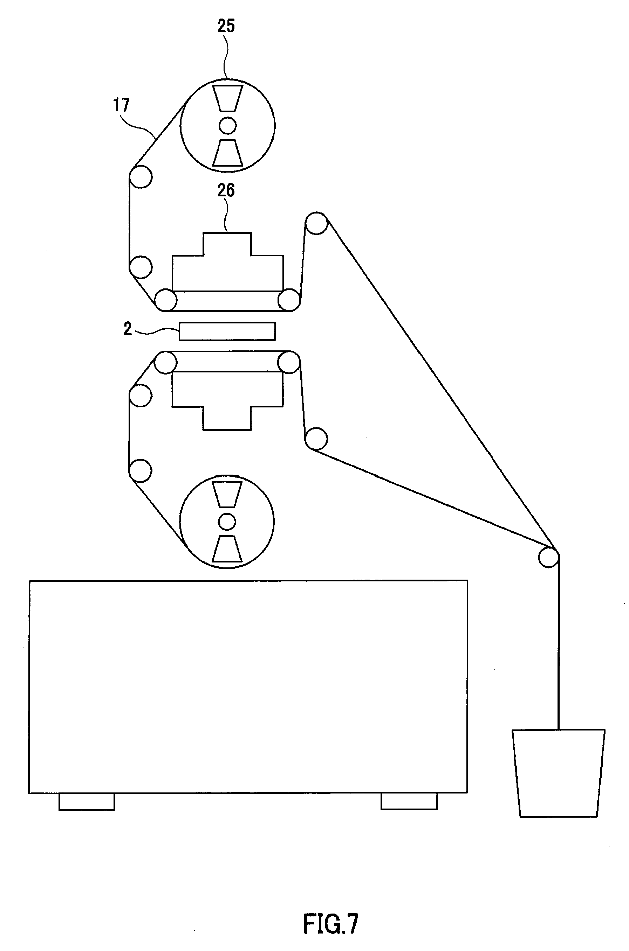

In the process for temporarily bonding the conductive adhesive film 17 onto the electrodes 11 and 13, as shown in FIG. 7, the adhesive conductive film 17 drawn from the reel 25 is cut in accordance with the lengths of the respective electrodes 11 and 13, and transported onto the respective electrodes 11 and 13. Next, by using a heating bonder 26, the binder resin layer is temporarily cured to such a degree as to exhibit flowability although not mainly cured, and a temporarily bonding process is carried out.

Next, the solar cell 2 is subjected to a process for detecting a positional shift from the bonding position of the conductive adhesive film 17. This process is carried out, for example, by using a bonding position inspection device 30. The bonding position inspection device 30 generates multivalued data, for example, binary data, based upon luminance or color difference of a surface image of the solar cell 2, and by collating the data with reference data preliminarily registered, determines whether or not the conductive adhesive film 17 is temporarily bonded to the predetermined position. Additionally, not limited to the bonding position inspection device 30 to be explained below, all kinds of inspection techniques that can provide the same functions may be certainly used as the present technique.

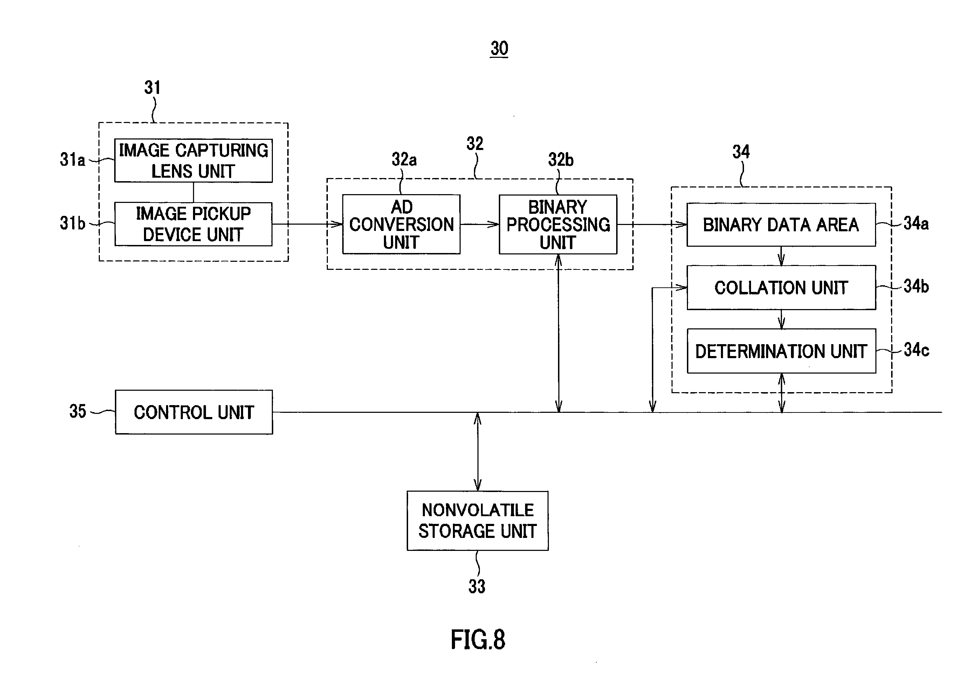

As shown in Fig. 8, the bonding position inspection device 30 is provided with an image capturing unit 31 that captures a surface image of the solar cell 2, a binary unit 32 that carries out predetermined signal processing on an image signal supplied from the image capturing unit 31, a nonvolatile storage unit 33 in which appropriate positional information of the conductive adhesive film 17 after the signal processing is registered, a positional shift detection unit 34 for detecting a positional shift of the conductive adhesive film 17, and a control unit 35 for controlling the entire device.

The image capturing unit 31 is provided with an image capturing lens unit 31a for use in capturing an image, and an image pickup device unit 31b such as a CCD, CMOS, or the like, for use in acquiring a picture image that is made incident thereon through the image capturing lens unit 31a. Moreover, after carrying out positional adjustments relative to alignment marks preliminarily formed on the light-receiving surface and the back surface of the solar cell 2 or a reference position such as an outside edge of the solar cell 2, the image capturing unit 31 captures an image of the light-receiving surface or the back surface of the solar cell 2 on which the conductive adhesive film 17 has been temporarily bonded.

The binary unit 32 is provided with an AD conversion unit 32a that A/D converts a signal acquired by the image pickup device unit 31b and a binary processing unit 32b that carries out a binary process on data converted by the AD conversion unit 32a. The binary processing unit 32b carries out the binary process on digital data supplied from the AD conversion unit 32a by using a predetermined system. The image data of the solar cell 2 subjected to the binary process are converted to a binary image in which the respective pixels forming the surface of the solar cell 2 or the conductive adhesive film 17 have a value of 0 or 1. As the system for the binary process, a conventionally known system, such as a system for comparing the sizes of the respective pixels with the average value of the entire image and a system for comparing the sizes thereof with the average value within an appropriate range on the periphery of a pixel on which attention is focused, may be used.

With respect to a light-receiving surface image of the solar cell 2, the binary unit 32 converts the white-based conductive adhesive film 17 into a white image, while converting the other regions on the light-receiving surface into a black image.

Moreover, with respect to a back surface of the solar cell 2 on which an Al electrode or an Ag electrode is formed over the entire surface, the binary unit 32 converts the black-based conductive adhesive film 17 into a black image, with the other regions on the back surface being converted into white.

The nonvolatile storage unit 33 is configured by, for example, an EEPROM, a flash ROM or the like, and stores and maintains reference positional information (coordinate values) of the conductive adhesive film 17 preliminarily bonded temporarily onto the busbar electrode 11 or the tab wire connection portion 14 of the solar cell 2 appropriately. The reference positional information, which is composed of, for example, the coordinates of respective pixels and binary information set in association with the respective coordinates, is set by reference to alignment marks preliminary attached to the solar cell 2 and the outside edge of the solar cell 2.

The positional shift detection unit 34 is constituted by a binary data area 34a in which binary data subjected to binary processing in the binary unit 32 are temporarily stored, a collation unit 34b that collates reference positional information (coordinate value) stored in the nonvolatile storage unit 33 with the positional information (coordinate value) of the conductive adhesive film 17 on the solar cell 2 generated in the binary unit 32, and a determination unit 34c that determines whether or not the amount of a positional shift is within a predetermined range as a result of the collation. The collation unit 34b compares the coordinates of the solar cell 2 stored in the binary data area 34a with corresponding coordinates of each of pieces of binary information stored in the nonvolatile storage unit 33 so as to carry out calculations as to how much degree the bonding position of the conductive adhesive film 17 deviates from the predetermined position stored in the nonvolatile storage unit 33. The determination unit 34c determines whether or not the amount of a shift calculated by the collation unit 34b is located within predetermined permissible values.

After the conductive adhesive film 17 has been temporarily bonded to the solar cell 2, the control unit 35 allows the image capturing unit 31 to capture an image of the surface (light-receiving surface and back surface) of the solar cell 2 to which the conductive adhesive film 17 has been temporarily bonded, and also allows the binary unit 32 to generate binary image data (coordinate values) on the surface of the solar cell 2.

Next, by using the positional shift detection unit 34, the control unit 35 collates the positional information (coordinate values) of the conductive adhesive film 17 with the reference positional information (coordinate values) of the conductive adhesive film 17 temporarily bonded thereto appropriately, which has been preliminarily stored in the nonvolatile storage unit 33. Moreover, the control unit 35 determines whether or not the amount of the positional shift is located within a predetermined range based upon the result of collation by using the determination unit 34c.

As a result of the determination, a solar cell 2 whose temporarily bonding position of the conductive adhesive film 17 is not deviated or whose amount of shift is located within the predetermined range is regarded as being properly subjected to the temporarily bonding process, and subjected to a connecting process with tab wires 3, while a solar cell 2 whose amount of shift exceeds the predetermined range is subjected to a repairing process in which its conductive adhesive film 17 is separated therefrom, and a temporarily bonding process is again carried out thereon.

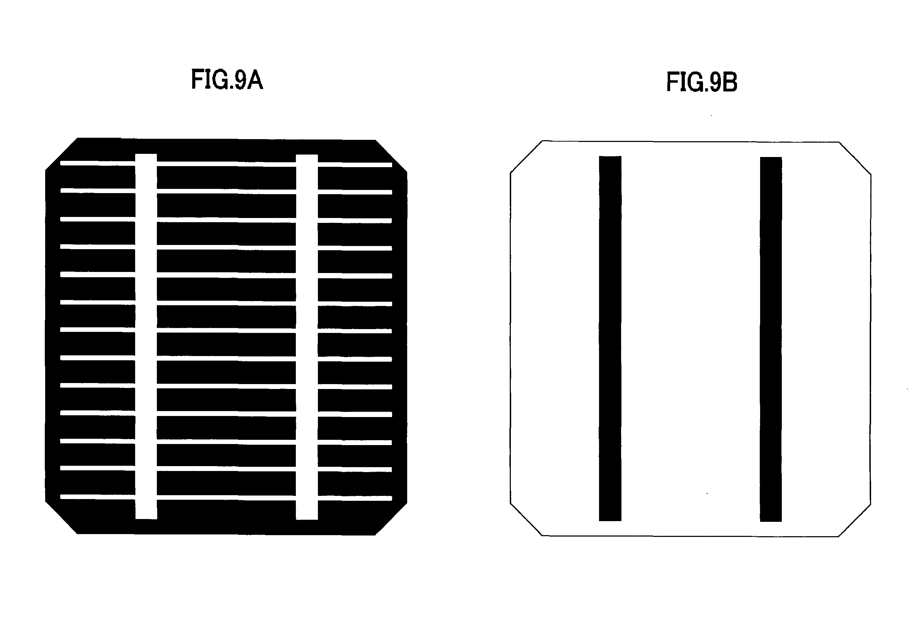

Figs. 9A and 9B show one example of a binary image of the solar cell 2. As shown in Fig. 9A, in a state where two busbar electrodes 11 are formed on the light-receiving surface of the solar cell 2, with conductive adhesive films 17 being temporarily bonded to the respective busbar electrodes 11, finger electrodes 12 and the conductive adhesive film 17 are converted to white, and the other regions of the light-receiving surface are inverted to black. Moreover, as shown in Fig. 9B, on the back surface of the solar cell 2, a back surface electrode 13 made of Al or Ag is formed over the entire surface, and in a state where the two conductive films 17 have been temporarily bonded onto tab line connection portions 14, the conductive adhesive films 17 are converted to black, while the other regions on the back surface are converted to white.

The control unit 35 focuses attention on a region on which the conductive adhesive film 17 is temporarily bonded and pixels on the periphery of the region among data stored in the binary data area 34a and binary image data stored in the nonvolatile storage unit 33 by using the collation unit 34b, and compares the coordinates of the corresponding attention pixel and binary information associated with the corresponding coordinates so as to calculate an amount of a shift. Then, the control unit 35 determines whether or not the amount of shift is located within a predetermined range in the determination unit 34c, and a solar cell 2 whose amount of shift is located within a predetermined range is regarded as being properly subjected to the temporarily bonding process, and subjected to a connecting process with tab wires 3.

### [Tab Wire Connection Process]

The solar cell 2 on which the conductive adhesive films 17 have been appropriately bonded temporarily is subjected to a bonding process in which the tab wires 3 cut into predetermined lengths are superposed and arranged on the conductive adhesive films 17. Thereafter, the conductive adhesive films 17 are heated and pressed at predetermined temperature and pressure by a heating bonder on the tab wires 3 so that excessive binder resin 22 is allowed to flow out between the respective electrodes 11, 13 and the tab wires 3, with conductive particles 23 being sandwiched between the tab wires 3 and the respective electrodes 11, 13; thus, the binder resin 22 is cured in this state. Consequently, the conductive adhesive films 17 allow the tab wires 3 to be bonded on the respective electrodes, while the conductive particles 23 are made in contact with the busbar electrodes 11 and the back surface electrode 13 so as to be conducted and connected.

In this manner, the solar cells 2 are successively connected to one another by the tab wires 3 so that a string 4 and a matrix 5 are successively formed. Next, the plural solar cells 2 forming the matrix 5 are sealed between a transparent surface cover 7 made of glass, a translucent plastic material, or the like and a back sheet 8 made of glass, a PET (Poly Ethylene Terephthalate) film, or the like, by using a sheet 6 of a sealing material having a translucent property, made of ethylene vinyl acetate resin (EVA) or the like. Lastly, a metal frame 9 made of aluminum or the like is attached on the periphery thereof so that a solar cell module is formed.

### [Busbarless]

As described earlier, in addition to a configuration in which, as described earlier, busbar electrodes 11 that are virtually orthogonal to the finger electrodes 12 are formed on the light-receiving surface of the solar cell 2, with the conductive adhesive films 17 and the tab wires 3 being stacked on the busbar electrodes 11, the solar cell module 1 may have a so-called busbarless configuration in which, without installing the busbar electrodes 11, the conductive adhesive films 17 and the tab wires 3 are stacked in a manner so as to be orthogonal to the finger electrodes 12.

### [One Lot Laminate]

Moreover, in addition to the above-mentioned manufacturing process in which, after the conductive adhesive films 17 and the tab wires 3 have been arranged on the respective electrodes 11 and 13, heating and pressing processes are carried out on the tab wires 3 by a heating bonder, another process may be used to produce the solar cell module 1 in which, after the conductive adhesive films 17, the tab wires 3 and a translucent sealing material sheet made of EVA or the like for use in sealing the solar cell 2 have been successively stacked on the surface and the back surface of the solar cell 2, a laminating process of one lot is carried out thereon by using a reduced-pressure laminator so that the tab wires 3 are heated and pressed onto the respective electrodes 11 and 13.

### [Effects of Present Invention]

In accordance with the present invention, since the presence or absence of a positional shift of the conductive adhesive film 17 is detected prior to connection with the tab wires 3 , the connecting process can be carried out, with the tab wires 3 being completely superposed on the conductive adhesive film 17. Thus, the solar cell module 1 makes it possible to ensure the bonding area between the tab wires 3 and the busbar electrodes 11 or the tab wires 14, and consequently to maintain mechanical connection strength and electrical connection reliability, while improving the yield of the strings.

Moreover, in accordance with the present invention, the presence or absence of a positional shift of the conductive adhesive film 17 can be detected prior to the connection with the tab wires 3, and in the case when any positional shift exceeding a permissible amount, a repairing process can be carried out thereon, thereby making it possible to prevent the connection with the tab wires 3 from being carried out with the positional shift occurring therein.

### EXAMPLES

Next, the following description will discuss examples of a case in which in a positional shift inspection for a conductive adhesive film using a binary image, a conductive adhesive film 17 having a color that is recognized as a color different from the color of the bonding surface of the solar cell 2 when image processed, in comparison with a case in which another conductive adhesive film is used.

In this positional shift inspection, a conductive adhesive film is temporarily bonded to each of a light-receiving surface and a back surface of a solar cell, and as described earlier, image data of the solar cell on which the conductive adhesive film has been temporarily bonded are subjected to a binary process to find respective coordinates and binary information in association with the coordinates so that by comparing the information with reference positional information of the conductive adhesive film temporarily bonded appropriately, an amount of a positional shift is obtained. In the present example, one of two conductive adhesive films is temporarily bonded to the appropriate temporarily bonding position, with the other conductive adhesive film being temporarily bonded to a position shifted from the appropriate temporarily bonding position, so that examinations are carried out as to whether or not the positional shift can be detected.

As the solar cell, a polycrystal silicon cell of 6 inches was used, and heating and pressing conditions of the respective conductive adhesive films were set to 180 °C, 15 seconds and 2MPa. The respective conductive adhesive films were obtained by applying a resin forming solution, which was prepared by dispersing conductive particles uniformly in a mixed solution in which an epoxy resin and a line-material curing agent were dissolved by using an organic solvent, to a peeling base member with a fixed thickness (25µm after being dried), and dried thereon. Moreover, the size of the respective conductive adhesive films was set to 2 mm × 150 mm.

In example 1, the conductive adhesive film 17 having a color recognized as a different color from the color of the bonding surface of the solar cell 2 when image-processed was used. That is, the conductive adhesive film 17 to be temporarily bonded to the light-receiving surface side of the solar cell 2 was colored into a white-based color by adding titanium oxide or zinc oxide to the resin-forming solution, and the conductive adhesive film 17 to be temporarily bonded to the back surface was colored into a black-based color by adding carbon black to the resin-forming solution.

In comparative example 1, a conventional conductive adhesive film 18 without carrying out any coloring treatment thereon was used. The conductive adhesive film 18 of comparative example 1 was semi-transparent.

In comparative example 2, a conductive adhesive film 19 colored into white by adding titanium oxide or zinc oxide to the resin-forming solution was used.

In comparative example 3, a conductive adhesive film 20 colored into black by adding carbon black to the resin-forming solution was used.

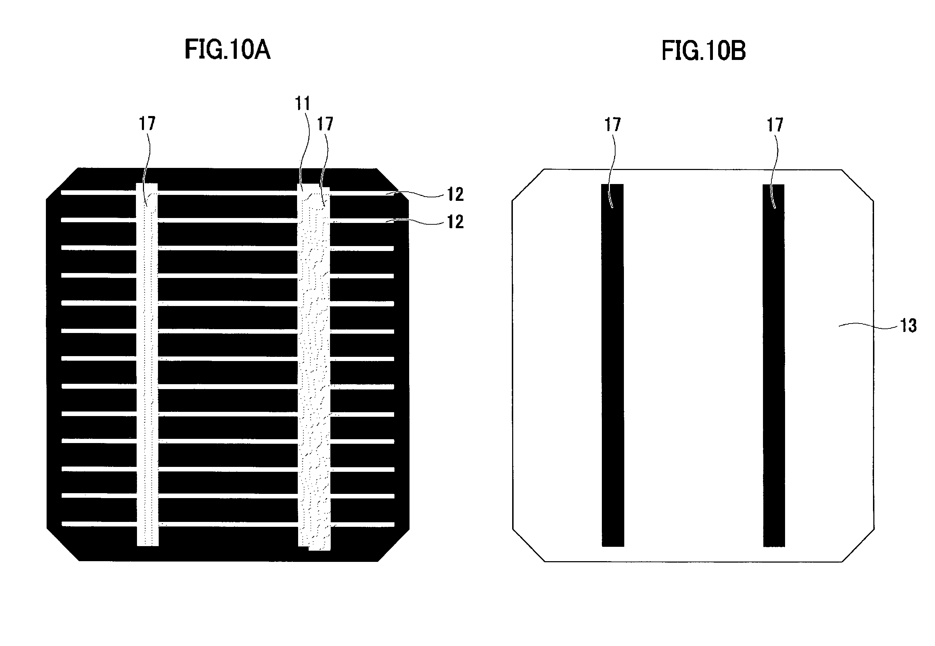

Table 1 shows the results of detection, and Figs. 10 to 14 show binary images relating to the examples and the comparative example.

**[Table 1]**

| | Example 1 Light receiving surface: White Back surface: Black | Comparative Example 1 Light receiving surface: Semi-transparent Back surface: Semi-transparent] | Comparative Example 2 Light receiving surface: White Back surface: White | Comparative Example 3 Light receiving surface: Black Back surface: Black |
|---|---|---|---|---|
| Yes/No of light-receiving surface determination | ○ | × | ○ | × |
| Yes/No of back surface determination | ○ | × | × | ○ |
| General determination | ⊚ | × | × | × |

Figs. 10A and 10B show a binary image of the solar cell relating to example 1. In example 1, on the light-receiving surface, the conductive adhesive film is converted into white (Fig. 10A) in contrast to the light-receiving surface converted to black, while on the back surface, the conductive adhesive film is converted into black (Fig. 10B) in contrast to the back surface converted into white. Therefore, in example 1, contrast and determination between binary data in an attention pixel including a peripheral portion of the appropriate temporarily bonded position can be positively carried out.

That is, as shown in Fig. 10A, it is found that on the light-receiving surface, the conductive adhesive film 17 on the left side is temporality bonded to an appropriate position. In contrast, since the conductive adhesive film 17 on the right side is temporarily bonded with a shift from the appropriate temporarily bonding position, the busbar electrode 11 converted into white is exposed. For this reason, since coordinates that should be converted into black originally are converted into white, it is found that the conductive adhesive film 17 is temporarily bonded with a shift from the appropriate temporarily bonding position.

Moreover, as shown in Fig. 10B, on the back surface also, in the case when temporarily bonded with a shift from the appropriate temporarily bonding position, since coordinates that should be converted into white originally are converted into black by the conductive adhesive film 17, with the coordinates that should be converted into black originally being converted into white by the back surface electrode 13, it is found that the conductive adhesive film 17 is temporarily bonded with a shift from the appropriate temporarily bonding position.

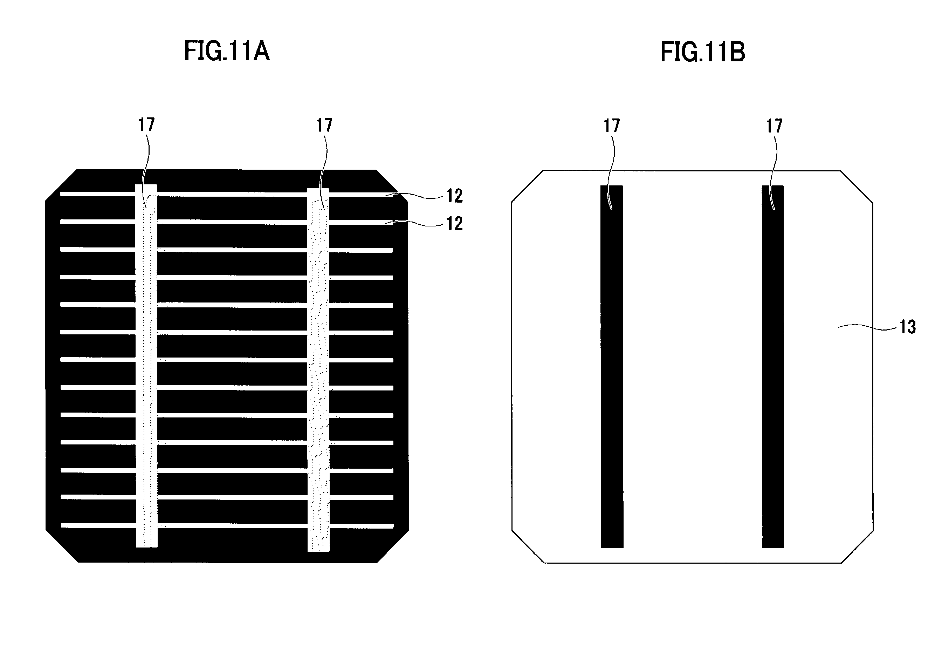

Furthermore, by using the conductive adhesive film 17 relating to example 1, even in the case of a solar cell with a so-called busbarless configuration without having the busbar electrodes 12, a shift from the temporarily bonding position can be easily found. That is, as shown in Fig. 11A, in the case when, on the light-receiving surface, temporarily bonded with a shift from the appropriate temporarily bonding position, since coordinates that should be converted into white originally are converted into black by the light-receiving surface, with the coordinates that should be converted into black originally being converted white by the conductive adhesive film 17, it is found that the conductive adhesive film 17 is temporarily bonded with a shift from the appropriate temporarily bonding position.

Moreover, as shown in Fig. 11B, on the back surface also, in the case when temporarily bonded with a shift from the appropriate temporarily bonding position, since coordinates that should be converted into white originally are converted into black by the conductive adhesive film 17, with the coordinates that should be converted into black originally being converted into white by the back electrode 13, it is found that the conductive adhesive film 17 is temporarily bonded with a shift from the appropriate temporarily bonding position.

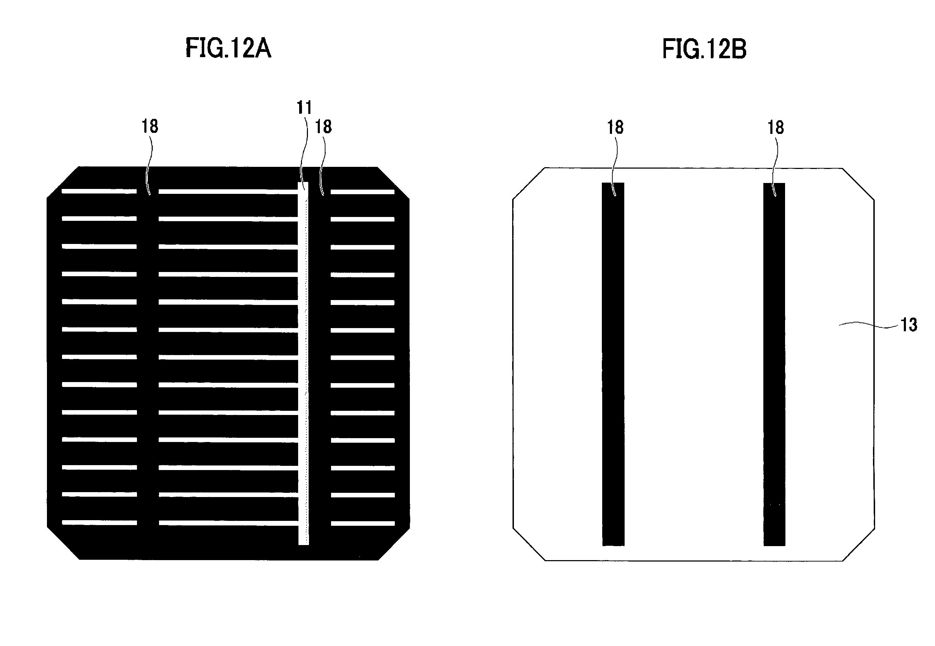

Figs. 12A and 12B show a binary image of the solar cell relating to comparative example 1. As shown in Fig. 12A, since a conductive adhesive film 18 was semi-transparent, it was converted into black when subjected to a binary process in comparative example 1. For this reason, on the light-receiving surface, the conductive adhesive film 18 was not distinguished from the light-receiving surface, failing to detect the presence or absence and the amount of a positional shift.

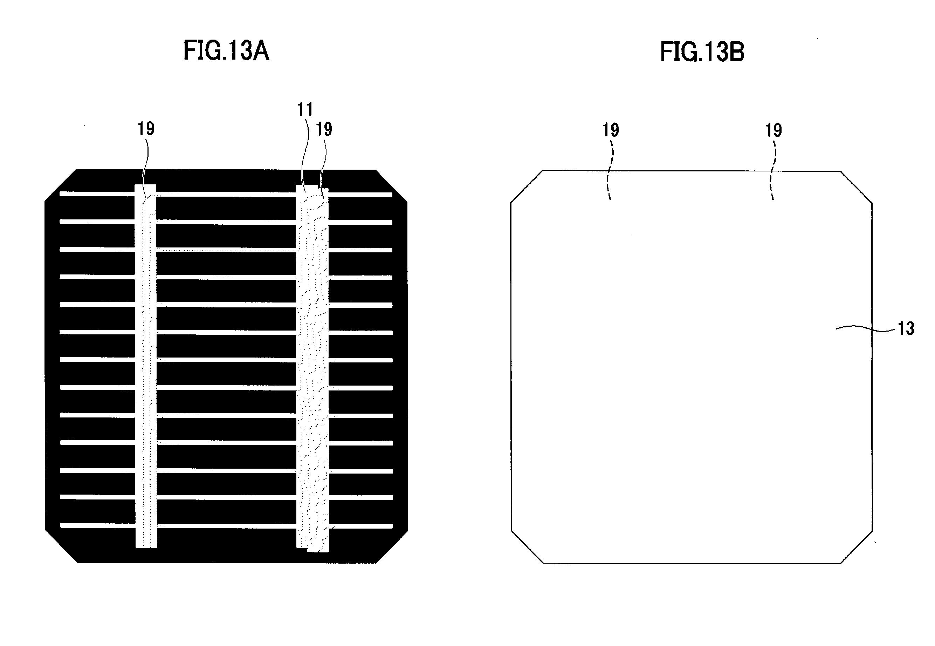

Figs. 13A and 13B show a binary image of the solar cell relating to comparative example 2. As shown in Fig. 13B, since a conductive adhesive film 19 was colored so as to be converted into white when subjected to a binary process in comparative example 2, the conductive adhesive film 19 was not distinguished from the back surface electrode 13 of the solar cell on the back surface side, failing to detect the presence or absence and the amount of a positional shift.

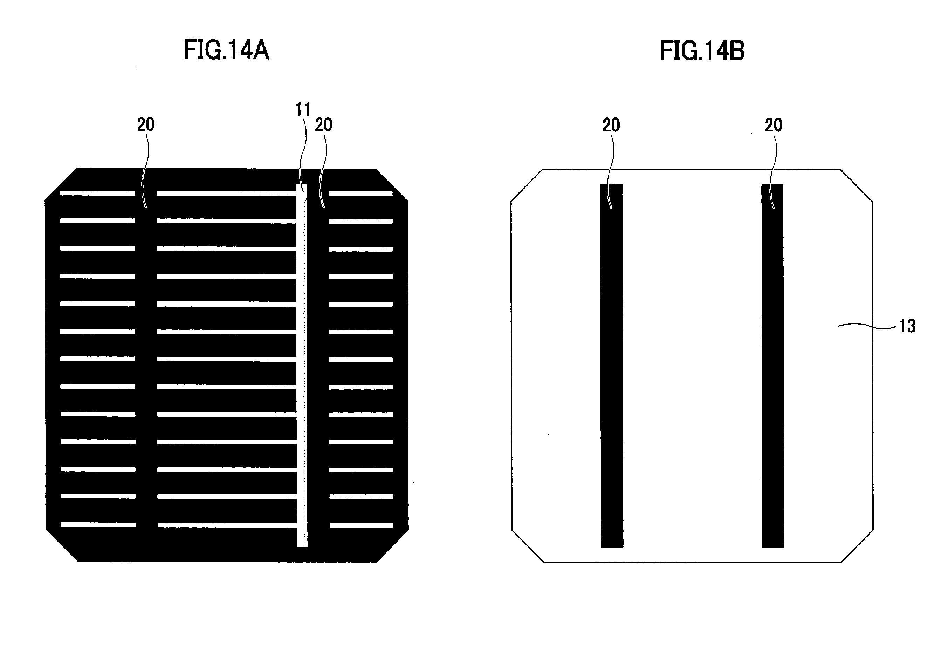

Figs. 14A and 14B show a binary image of the solar cell relating to comparative example 3. As shown in Fig. 14A, since a conductive adhesive film 20 was colored so as to be converted into black when subjected to a binary process in comparative example 3, the conductive adhesive film 20 was not distinguished from the light-receiving surface electrode of the solar cell on the light-receiving surface side, failing to detect the presence or absence and the amount of a positional shift. In particular, in a solar cell 2 of a busbarless configuration, since no busbar electrodes 12 to be converted into white were formed, it was not possible to detect the amount of a positional shift based upon a relative positional relationship to the busbar electrodes 12.

### [Positional Inspection for Temporarily Bonding Position of Tab Wires]

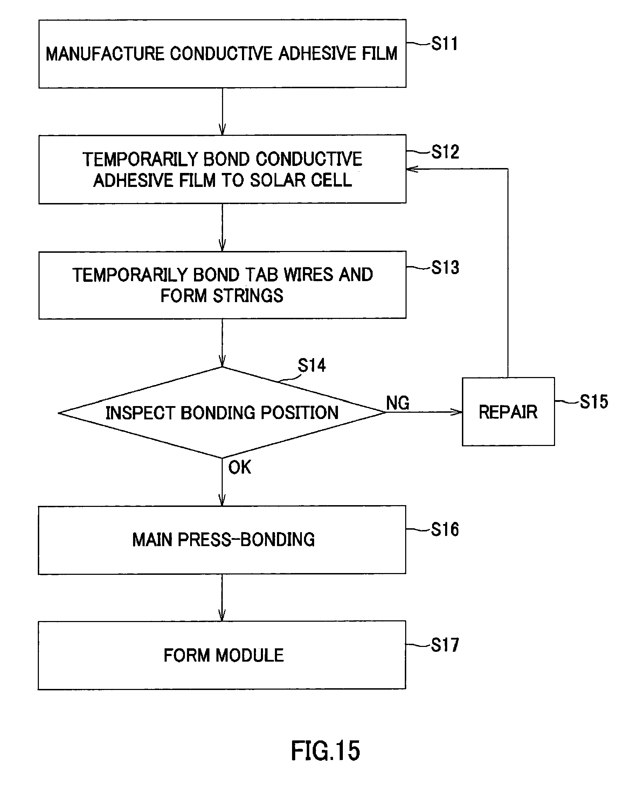

As shown in Fig. 15, as another embodiment, a conductive adhesive film 17 is temporarily bonded to a solar cell 2, and after tab wires 3 have been temporarily bonded onto the conductive adhesive film 17, an inspection for the bonding position may be carried out prior to a main press-bonding process. That is, as shown in Fig. 15, with respect to a solar module 1, the conductive adhesive film 17 is manufactured (step S11), and after the conductive adhesive film 17 has been bonded to a light-receiving surface and a back surface of the solar cell 2 (step S12), tab wires 3 are temporarily bonded onto the entire plural solar cells 2 so that strings 4 are formed (step S13). Thereafter, the solar cell is subjected to an inspection process for the bonding position (step S 14), and in the case when a positional shift is detected by the inspection for the bonding position, a repairing process is carried out thereon (step S 15) so that the conductive adhesive film 17 is again temporarily bonded thereto. Moreover, in the case when no positional shift is detected, by carrying out heating and pressing processes onto the tab wires 3, the tab wires 3 and the respective electrodes of the solar cell 2 are subjected to a main press-bonding process via the conductive adhesive film 17 (step S 16) so that by sealing the gap between the surface cover 7 and the back sheet 8 with a sealing material sheet such as EVA or the like (step S 17), the solar cell module 1 is manufactured.

In this case, the tab wires 3 are coated with solder or the like so as to be converted to a white color when subjected to a binary process, and formed so as to have a width larger than the width of the conductive adhesive film 17.

In the case when both of the conductive adhesive film 17 and the tab wires 3 are temporarily bonded to appropriate positions, the solar cell 2 has only its tab wires 3 photographed on the light-receiving surface side. Therefore, since the positional information (coordinate value) of the tab wires 3 is virtually coincident with reference positional information (coordinate value) of the tab wires 3 when the tab wires 3 are temporarily bonded to an appropriate temporarily bonding position, it is found that both of the conductive adhesive film 17 and the tab wires 3 are temporarily bonded to appropriate positions.

On the other hand, in the solar cell 2, in the case when either the conductive adhesive film 17 or the tab wires 3 is temporarily bonded with a shift from the appropriate temporarily bonding position, the widths of the tab wires 3 and the conductive adhesive film 17 converted into a white color are widened from a predetermined width on the light-receiving surface side. Therefore, since the positional information (coordinate value) of the tab wires 3 and the conductive adhesive film 17 is not coincident with reference positional information (coordinate value) of the tab wires 3 when the tab wires 3 are temporarily bonded to an appropriate temporarily bonding position, it is found that a bonding shift occurs.

In the case when both of the conductive adhesive film 17 and the tab wires 3 are temporarily bonded to appropriate positions, the solar cell 2 has its conductive adhesive film 17 covered with the tab wires 3 on the back surface side so that the front surface side of the back surface is converted into white. Therefore, since the positional information (coordinate value) of the tab wires 3 is coincident with reference positional information (coordinate value) of the tab wires 3 when the tab wires 3 are temporarily bonded to an appropriate temporarily bonding position, it is found that both of the conductive adhesive film 17 and the tab wires 3 are temporarily bonded to appropriate positions.

On the other hand, in the solar cell 2, in the case when either the conductive adhesive film 17 or the tab wires 3 is temporarily bonded with a shift from the appropriate temporarily bonding position, the conductive adhesive film 17 converted into black is exposed on the back surface side. Therefore, since the positional information (coordinate value) of the tab wires 3 and the conductive adhesive film 17 is not coincident with reference positional information (coordinate value) of the tab wires 3 when the tab wires 3 are temporarily bonded to an appropriate temporarily bonding position, it is found that a bonding shift occurs.

As a result of the collation, in the case when both of the conductive adhesive film 17 and the tab wires 3 are temporarily bonded to appropriate positions, the solar cell 2 is subjected to a main press-bonding process of the tab wires 3. As a result of the collation, in the case when the tab wires 3 are not temporarily bonded to appropriate temporarily bonding positions, the solar cell 2 is subjected to a repairing process so that the tab wires 3 are again bonded thereto.

Additionally, in the case when, after the tab wires 3 have been temporarily bonded, the inspection for the bonding position is carried out prior to the main press-bonding process, the tab wires 3 are coated with a material having a color different from the colors of the light-receiving surface and back surface of the solar cell 2 and the conductive adhesive film 17, and based upon luminance or color difference of the surface image of the solar cell 2 on which the tab wires 3 have been temporarily bonded, ternary data are generated; thus, the data may be collated with reference data preliminarily registered. In this manner, the conductive adhesive film 17, the tab wires 3 and the other regions on the surface of the solar cell 2 are distinguished, and by collating the resulting data with coordinate values of reference data, it becomes possible to determine which one of the conductive adhesive film 17 and the tab wires 3 is temporarily bonded, with how much degree of a shift.

As a result of the inspection for the bonding position, in the case when both of the conductive adhesive film 17 and the tab wires 3 are temporarily bonded to appropriate positions, the solar cell 2 is subjected to a main press-bonding process of the tab wires 3. In the main press-bonding process, in addition to a process for carrying out heating and pressing operations onto the tab wires 3 by using a heating bonder, another process may be used in which, after translucent sealing material sheets such as EVA or the like for sealing the solar cell 2 have been successively stacked on the surface and the back surface of solar cell 2, a laminating process of one lot is carried out thereon by using a reduced-pressure laminator so that the tab wires 3 may be heated and pressed onto the respective electrodes 11 and 13.

### [Double-Surface Light-Receiving Type]

Moreover, the solar cell module relating to the present embodiment may be applied to a solar cell of a so-called double-surface light-receiving type, with two surfaces of the solar cell serving as light-receiving surfaces.

### Reference Signs List

1...solar cell module, 2...solar cell, 3...tab wire, 4...strings, 5...matrix, 6...sheet, 7...surface cover, 8...back sheet, 9...metal frame, 10...photoelectric conversion element, 11...busbar electrode, 12...finger electrode, 13...back surface electrode, 14...tab wire connection portion, 17...conductive adhesive film, 22...binder resin, 23...conductive particles, 24...peeling base member, 25...reel, 30...bonding position inspection device, 31...image capturing device

## Claims

1. A solar cell module comprising:
a plurality of solar cells;
electrodes respectively formed on a light-receiving surface of each solar cell and a back surface of an adjacent solar cell; and
a plurality of tab wires that are bonded onto the electrodes with an adhesive film interposed therebetween so as to mutually connect the plural solar cells,
wherein the adhesive film has a color that is recognized as a different color from the color of the bonding surfaces of the solar cells when image-processed.

2. The solar cell module according to claim 1, wherein the adhesive film is colored into a different color from the color of the bonding surfaces of the solar cells when image-processed.

3. The solar cell module according to claim 1 or 2, wherein the image processing at least makes the bonding surfaces of the solar cells and the adhesive film distinguished from each other.

4. The solar cell module according to claim 3, wherein the image processing is a binary process.

5. The solar cell module according to any one of claims 1 to 4, wherein the solar cell module has a busbarless structure without busbar electrodes.

6. The solar cell module according to claim 3, wherein the image processing further distinguishes the tab wires bonded to the bonding surfaces of the solar cell module with the adhesive film interposed therebetween.

7. The solar cell module according to any one of claims 1 to 6, wherein, when image-processed, the adhesive film disposed on the light-receiving surface of the solar cell and the adhesive film disposed on the back surface of the solar cell are recognized as mutually different colors.

8. The solar cell module according to claim 7, wherein the adhesive film disposed on the light-receiving surface of the solar cell has a color recognized as a white color when image-processed into a binary image, and the adhesive film disposed on the back surface of the solar cell has a color recognized as a block color when image-processed into a binary image.

9. A method for manufacturing a solar cell module comprising the steps of:
carrying out an adhesive film disposing process in which an adhesive film is temporarily bonded to a predetermined bonding position on a surface of each solar cell;
capturing an image of the surface of the solar cells on which the adhesive film has been temporarily bonded;
by image processing image data on the surface of the solar cell, detecting whether or not the adhesive film is temporarily bonded to the predetermined position;
carrying out a tab wire disposing step in which tab wires are temporarily bonded onto the adhesive film at a predetermined bonding position on the surface of the solar cell; and
applying heating and pressing processes onto the tab wires so that the tab wires are connected to the surface of the solar cell by the adhesive film,
wherein the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.

10. The method for manufacturing a solar cell module according to claim 9, wherein in the detecting step, when any positional shift of the adhesive film is detected, the adhesive film is separated so that the adhesive film disposing process is again carried out.

11. The method for manufacturing a solar cell module according to claim 9, wherein the detecting step is carried out next to the adhesive film disposing step and the tab wire disposing step.

12. The method for manufacturing a solar cell module according to any one of claims 9 to 11, wherein the image processing is a binary process.

13. The method for manufacturing a solar cell module according to any one of claims 9 to 11, wherein the image processing further makes the adhesive film distinguished from the tab wires bonded to the bonding surface of the solar cell with the adhesive film interposed therebetween.

14. The method for manufacturing a solar cell module according to any one of claims 9 to 12, wherein when image-processed, the adhesive film disposed on the light-receiving surfaces of the solar cells and the adhesive film disposed on the back surfaces of the solar cells are recognized as mutually different colors.

15. The method for manufacturing a solar cell module according to claim 14, wherein the adhesive film disposed on the light-receiving surfaces of the solar cells has a color recognized as a white color when image-processed into a binary image, and the adhesive film disposed on the back surfaces of the solar cells has a color recognized as a block color when image-processed into a binary image.

16. A method for bonding an adhesive film comprising the steps of:
carrying out an adhesive film disposing process in which an adhesive film is temporarily bonded to a predetermined bonding position on a surface of each solar cell;
capturing an image of the surface of the solar cells on which the adhesive film has been temporarily bonded; and
by image processing image data on the surface of the solar cell, detecting whether or not the adhesive film is temporarily bonded to the predetermined position,
wherein the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.

17. The method for bonding an adhesive film according to claim 16, wherein in the detecting step, when any positional shift of the adhesive film is detected, the adhesive film is separated so that the adhesive film disposing process is again carried out.

18. The method for bonding an adhesive film according to claim 16 or 17, wherein the image processing is a binary process.

19. The method for bonding an adhesive film according to any one of claims 16 to 18, wherein when image-processed, the adhesive film disposed on the light-receiving surfaces of the solar cells and the adhesive film disposed on the back surfaces of the solar cells are recognized as mutually different colors.

20. The method for bonding an adhesive film according to claim 19, wherein the adhesive film disposed on the light-receiving surfaces of the solar cells has a color recognized as a white color when image-processed into a binary image, and the adhesive film disposed on the back surfaces of the solar cells has a color recognized as a block color when image-processed into a binary image.

21. A method for inspecting an adhesive film comprising the steps of:
carrying out an adhesive film disposing process in which an adhesive film is temporarily bonded to a predetermined bonding position on a surface of each solar cell;
capturing an image of the surface of the solar cells on which the adhesive film has been temporarily bonded; and
by image processing image data on the surface of the solar cell, detecting whether or not the adhesive film is temporarily bonded to the predetermined position,
wherein the adhesive film has a color recognized as a different color from the color of the surface of the solar cell when the image data are image-processed, and during the detecting step, based upon positional information of the adhesive film on the surface of the solar cell after the image processing, it is detected whether or not the temporarily bonding process has been carried out at the predetermined position on the bonding surface.
